# EUROPÄISCHE PATENTSCHRIFT

(11) **EP 2 351 117 B1**
(45) Veröffentlichungstag und Bekanntmachung des Hinweises auf die Patenterteilung: **08.09.2021**
(21) Anmeldenummer: 09771472.9
(22) Anmeldetag: 15.10.2009
(51) Int. Cl.: H01L 51/52

(54) **STRAHLUNGSEMITTIERENDE VORRICHTUNG**
RADIATION-EMITTING DEVICE
DISPOSITIF ÉMETTANT UN RAYONNEMENT

(30) Priorität: 31.10.2008 DE 102008054234
(43) Veröffentlichungstag der Anmeldung: 03.08.2011
(73) Patentinhaber: OSRAM OLED GmbH, 93055 Regensburg (DE)
(72) Erfinder: SCHMID, Günter, 91334 Hemhofen (DE); SEIDEL, Stefan, 93098 Mintraching (DE); KRAUSE, Ralf, 91058 Erlangen (DE)
(74) Vertreter: Epping - Hermann - Fischer
(86) Internationale Anmeldenummer: PCT/DE2009/001434
(87) Internationale Veröffentlichungsnummer: WO 2010/048920

(56) Entgegenhaltungen:
- WO-A1-2005/115059
- WO-A2-2006/130883
- US-A1- 2006 040 132
- US-A1- 2006 273 714
- US-A1- 2007 001 587
- US-A1- 2008 224 602
- KANNO HIROSHI ET AL: "White organic light-emitting device based on a compound fluorescent-phosphor-sensitized-fluorescen t emission layer" APPLIED PHYSICS LETTERS, AIP, AMERICAN INSTITUTE OF PHYSICS, MELVILLE, NY, US, Bd. 89, Nr. 14, 5. Oktober 2006 (2006-10-05), Seiten 143516-143516, XP012086214 ISSN: 0003-6951
- SEO J H ET AL: "Characteristics of white organic light-emitting diodes using heteroleptic iridium complexes for green and red phosphorescence" JAPANESE JOURNAL OF APPLIED PHYSICS, JAPAN SOCIETY OF APPLIED PHYSICS, TOKYO,JP, Bd. 47, Nr. 8, 1. August 2008 (2008-08-01) , Seiten 6987-6990, XP001521729 ISSN: 0021-4922
- SUN Y ET AL: "Management of singlet and triplet excitons for efficient white organic light-emitting devices" NATURE, NATURE PUBLISHING GROUP, LONDON, UK, Bd. 440, 13. April 2006 (2006-04-13), Seiten 908-912, XP002454798 ISSN: 0028-0836

## Beschreibung

Die vorliegende Erfindung betrifft eine strahlungsemittierende Vorrichtung mit fluoreszierenden und phosphoreszierenden Emitter-Schichten.

Diese Patentanmeldung beansprucht die Priorität der deutschen Patentanmeldung DE 10 2008 054 234. 2.

Bei strahlungsemittierenden Vorrichtungen mit fluoreszierenden und phosphoreszierenden Emittern hängen die Effizienz und die Beständigkeit der Vorrichtungen stark von der Effektivität und Nutzbarkeit der in der strahlungsemittierenden Vorrichtung erzeugten Strahlung ab.

Die Druckschrift US 2008/0224602 A1 offenbart eine weiße OLED mit zwei Emitterschichten, die jeweils zwei Teilschichten aufweisen und durch eine Zwischenschicht getrennt werden.

Die Druckschrift US 2007/0001587 A1 offenbart Tandem-OLEDs aus zwei lichtemittierenden Einheiten, die durch einen Zwischenverbinder verbunden sind.

Die Druckschrift WO 2005/115059 A1 offenbart ein weiß emittierendes Bauelement, bei dem zwei lichtemittierenden Einheiten mit jeweils zwei Emitterschichten übereinander angeordnet sind.

Die Druckschriften WO 2006/130883 A2 und US 2006/0273714 A1 offenbaren weiße OLEDs mit jeweils einer phosphoreszenten Schicht, die zwischen zwei fluoreszenten Schichten angeordnet ist.

Die Druckschrift "White organic light-emitting device based on a compound fluorescent-phosphor-sensitized-fluorescent emission layer" (H. Kanno et al., Appl. Phys. Lett. 89, 2006, 143516) offenbart eine weiße OLED mit drei Emitterschichten, die einen grünen phosphoreszenten Emitter oder einen blauen oder roten Fluorophor enthalten.

Die Druckschrift "Characteristics of white organic light-emitting diodes using heteroleptic iridium complexes for green and red phosphoresence" (J. H. Seo et al., Jpn. J. Appl. Phys., 47, 2008, 6987 bis 6990) offenbart eine weiße OLED, die rot, grün und blau emittierende Emitterschichten aufweist.

Die Druckschrift "Management of singlet and triplet excitons for efficient white organic light-emitting devices" (Y. Sun et al., Nature 440, 2006, 908 bis 912) offenbart eine OLED mit drei Emitterschichten, die einen blauen Fluorophor oder einen grünen oder roten phosphoreszenten Emitter enthalten.

Die Druckschrift US 2006/040132 A1 offenbart weiße Tandem-OLEDs, in denen mehrere weiß elektrolumineszierende Einheiten übereinander gestapelt und durch Zwischenschichten voneinander getrennt sind.

Aufgabe der Erfindung ist es, eine strahlungsemittierende Vorrichtung mit einer verbesserten Ausbeute an emittierter Strahlung bereitzustellen.

Diese Aufgabe wird durch eine strahlungsemittierende Vorrichtung gemäß den unabhängigen Ansprüchen gelöst. Weitere Ausgestaltungen sind Gegenstand von Unteransprüchen.

Eine strahlungsemittierende Vorrichtung gemäß der Erfindung ist geeignet elektromagnetische Strahlung zu emittieren, die eine Mischung von zumindest drei verschiedenen Teilstrahlungen eines ersten, zweiten und dritten Wellenlängenbereichs umfasst, wobei durch eine Überlagerung der Strahlung des ersten, des zweiten und des dritten Wellenlängenbereichs Weißlicht emittiert wird. Eine solche strahlungsemittierende Vorrichtung weist dabei
- ein Substrat,
- eine erste Elektrode und eine zweite Elektrode,
- wenigstens eine zwischen der ersten und zweiten Elektrode angeordnete erste Schichtenfolge, die zumindest eine erste und eine dritte Schicht mit jeweils einem ersten fluoreszierenden Emitter, der Strahlung in dem ersten Wellenlängenbereich emittiert, genau eine zweite Schicht mit einem ersten phosphoreszierendem Emitter, der ausschließlich Strahlung in dem zweiten Wellenlängenbereich emittiert, umfasst, wobei die zweite Schicht zwischen der ersten Schicht und der dritten Schicht angeordnet ist,
- wenigstens eine zwischen der ersten und zweiten Elektrode angeordnete zweite Schichtenfolge, die zumindest eine erste und eine dritte Schicht mit einem zweiten fluoreszierenden Emitter, der Strahlung in dem ersten Wellenlängenbereich emittiert, genau eine zweite Schicht mit einem zweiten phosphoreszierenden Emitter, der ausschließlich Strahlung in dem dritten Wellenlängenbereich emittiert, umfasst, wobei die zweite Schicht zwischen der ersten Schicht und der dritten Schicht angeordnet ist, und
- und wobei die fluoreszierenden Emitter der ersten und der zweiten Schichtenfolge Strahlung im blauen Wellenlängenbereich emittieren und der erste phosphoreszierende Emitter Strahlung im grünen Wellenlängenbereich und der zweite phosphoreszierende Emitter Strahlung im roten Wellenlängenbereich emittiert,
   - wenigstens eine Zwischenschicht, die frei ist von Emittermaterial und zwischen der ersten und zweiten Schichtenfolge angeordnet ist,
- zwischen der ersten Schicht und der zweiten Schicht und zwischen der zweiten Schicht und der dritten Schicht der ersten Schichtenfolge und zwischen der ersten Schicht und der zweiten Schicht und zwischen der zweiten Schicht und der dritten Schicht der zweiten Schichtenfolge jeweils eine Blockierschicht angeordnet ist und die erste Schichtenfolge aus der ersten Schicht, der zweiten Schicht, der dritten Schicht und den Blockierschichten besteht und die zweite Schichtenfolge aus der ersten Schicht, der zweiten Schicht, der dritten Schicht und den Blockierschichten besteht,
auf.

Die von der erfindungsgemäßen strahlungsemittierenden Vorrichtung emittierte Strahlung, im Folgenden auch als "Gesamtstrahlung" bezeichnet, ist eine Mischung von zumindest drei verschiedenen Teilstrahlungen eines ersten, eines zweiten und eines dritten Wellenlängenbereichs.

Diese Gesamtstrahlung vermittelt als Überlagerung der drei verschiedenen Teilstrahlungen des ersten, des zweiten und des dritten Wellenlängenbereichs einen bestimmten Farbeindruck. Obwohl dieser Farbeindruck ein von einem Beobachter wahrgenommener subjektiver Farbeindruck ist, wird die apparativ messbare Überlagerung der verschiedenen Teilstrahlungen des ersten, des zweiten und des dritten Wellenlängenbereichs nicht wesentlich von dem subjektiv gewonnenen Farbeindruck abweichen.

"Verschiedene Teilstrahlungen des ersten, des zweiten und des dritten Wellenlängenbereichs" sollen erfindungsgemäß drei Teilstrahlungen mit voneinander verschiedenen Emissionsspektren bezeichnen. Generell ist es dabei auch möglich, dass sich die Wellenlängenbereiche lediglich hinsichtlich ihres Emissionsmaximums unterscheiden; weiterhin ist es möglich, dass Strahlung einer konkreten emittierten Wellenlänge des ersten und/oder des zweiten und/oder des dritten Wellenlängenbereichs in wenigstens einem anderen des ersten und/oder zweiten und/oder dritten Wellenlängenbereichs fehlt. Üblicherweise liegt das Emissionsmaximum zumindest des ersten und des zweiten Wellenlängenbereichs sowie des zweiten und des dritten Wellenlängenbereichs in jeweils unterschiedlichen (der nachfolgend angegebenen) Wellenlängenbereiche der Farben rot, orange, gelb, grün, blau oder violett.

Die von der strahlungsemittierenden Vorrichtung emittierten Emissionsspektren liegen bevorzugt im sichtbaren Bereich von etwa 380 nm bis etwa 780 nm. Die Emissionsspektren der drei verschiedenen Teilstrahlungen des ersten, des zweiten und des dritten Wellenlängenbereichs können dann jeweils zum Beispiel rote Strahlung mit etwa 640 bis 780 nm, orange Strahlung mit etwa 600 bis 640 nm, gelbe Strahlung mit etwa 570 bis 600 nm, grüne Strahlung mit etwa 490 bis 570 nm, blaue Strahlung mit etwa 430 bis 490 nm, violette Strahlung mit etwa 380 bis 430 nm sowie Kombinationen derselben umfassen. Insbesondere liegen die Emissionsmaxima der drei verschiedenen Teilstrahlungen des ersten, des zweiten und des dritten Wellenlängenbereichs in einem der vorgenannten Wellenlängenbereiche der Farben rot, orange, gelb, grün, blau oder violett.

"Fluoreszenz" bezeichnet vorliegend eine spontane Emission von Licht beim Übergang eines angeregten Systems in einen Zustand niedriger Energie (Grundzustand), die ohne äußere Einwirkung erfolgt. Der angeregte Zustand eines fluoreszierenden Systems ist ein Singulett-Zustand.

"Phosphoreszenz" bezeichnet eine Strahlung, die beim Übergang eines angeregten Systems, eines Triplett-Zustands, in den Grundzustand abgegeben wird.

In den erfindungsgemäßen Schichtenfolgen sind jeweils wenigstens eine Schicht mit einem fluoreszierenden Emitter und wenigstens eine Schicht mit einem phosphoreszierenden Emitter aufeinander angeordnet.

Zwischen den wenigstens zwei Schichtenfolgen dieser Ausführungsform der strahlungsemittierenden Vorrichtung ist eine Zwischenschicht, die frei von Emittermaterial ist, angeordnet.

Dass die Zwischenschicht "frei von Emittermaterial" ist, bedeutet, dass die Zwischenschicht kein Material enthält, das bei der während des Betriebs der strahlungsemittierenden Vorrichtung angelegten Spannung elektromagnetische Strahlung im sichtbaren Bereich emittiert.

Die Zwischenschicht trennt die wenigstens zwei Schichtenfolgen funktional voneinander ab, so dass die strahlungsemittierende Vorrichtung derart ausgebildet sein kann, dass diese Schichtenfolgen während des Betriebs unabhängig voneinander beeinflussbar sind.

Bei alternativen Ausführungsformen mit mehr als zwei Schichtenfolgen kann die Zwischenschicht zwischen jeweils zwei Schichtenfolgen der strahlungsemittierenden Vorrichtung ausgeführt sein.

"Aufeinander angeordnet" bedeutet im Rahmen der vorliegenden Erfindung, dass eine Schicht unmittelbar in direktem mechanischem und/oder elektrischem Kontakt auf einer anderen Schicht angeordnet ist oder mittelbar auf einer anderen Schicht angeordnet ist, wobei dann weitere Schichten zwischen den angegebenen Schichten vorhanden sein können. Diese weiteren Schichten können dabei weitere strahlungsemittierende Schichten und/oder andere funktionelle Schichten sein, die z.B. dazu dienen, die Funktionalität und damit die Effizienz der strahlungsemittierenden Vorrichtung weiter zu verbessern. Die Positionsbezeichnung "über" bezeichnet die räumliche Anordnung einer Schicht infolge der aufeinander folgenden Abscheidung der verschiedenen Schichten während der Herstellung der strahlungsemittierenden Vorrichtung. Der Begriff soll hierbei jedoch nicht ausschließen, dass weitere Schichten zwischen zwei derart aufeinander angeordneten Schichten vorhanden sein können.

Der Begriff "zwischen den wenigstens zwei Schichtenfolgen angeordnet" schließt sowohl eine unmittelbare wie auch eine mittelbare Anordnung, wie sie vorstehend in Bezug auf den Begriff "aufeinander angeordnet" definiert wurde, ein.

Im Folgenden werden kurz die einzelnen Bauteile der strahlungsemittierenden Vorrichtung der vorliegenden Erfindung definiert.

Ein "Substrat" umfasst gemäß der vorliegenden Erfindung zum Beispiel ein Substrat, wie es im Stand der Technik herkömmlich für eine strahlungsemittierende Vorrichtung verwendet wird. Beispielsweise kann das Substrat Glas, Quarz, Kunststofffolien, Metall, Metallfolien, Siliziumwafer oder ein anderes geeignetes Substratmaterial umfassen. Ist die strahlungsemittierende Vorrichtung zum Beispiel als so genannter "Bottom-Emitter" ausgeführt, ist das Substrat vorzugsweise transparent und beispielsweise als Glassubstrat ausgeführt.

In der erfindungsgemäßen strahlungsemittierenden Vorrichtung kann die erste Elektrode auf dem Substrat abgeschieden sein.

Die "erste Elektrode", wie sie hierin verwendet wird, kann zum einen eine Anode sein. Die Anode kann aus einem löcherinjizierenden Material bestehen. Als löcherinjizierendes Material kann jedes im Stand der Technik bekannte, löcherinjizierende Material verwendet werden. Ist die strahlungsemittierende Vorrichtung beispielsweise als "Bottom-Emitter" ausgebildet, so besteht die Anode üblicherweise aus einem transparenten Material. Beispielsweise kann sie aus transparenten leitenden Oxiden bestehen oder eine Schicht hieraus umfassen. Diese transparenten leitenden Oxide (transparent conductive oxides, "TCO") schließen Metalloxide, wie beispielsweise Zinkoxid, Zinnoxid, Cadmiumoxid, Titanoxid, Indiumoxid oder Indiumzinnoxid (ITO), Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide ein, sind jedoch nicht auf diese beschränkt. Die TCOs unterliegen dabei nicht zwingend einer stöchometrischen Zusammensetzung und können ferner auch p- oder n-dotiert sein.

Die zweite Elektrode ist über der ersten Elektrode angeordnet. Wenn die erste Elektrode eine Anode ist, ist die zweite Elektrode eine Kathode.

Die "Kathode" kann aus einem elektroneninjizierenden Material bestehen. Als Kathodenmaterialien können dabei im Stand der Technik übliche Kathodenmaterialien, insbesondere Aluminium, Barium, Indium, Silber, Gold, Magnesium, Calcium oder Lithium sowie Verbindungen, und Legierungen dieser Stoffe und Gemische der vorgenannten Elemente, Verbindungen und/oder Legierungen verwendet werden. Alternativ oder zusätzlich können auch eines oder mehrere der bei den Anoden-Materialien genannten TCOs enthalten sein bzw. kann die Kathode auch vollständig aus einem dieser Materialien bestehen. Die Kathode kann auch transparent ausgeführt sein.

In der strahlungsemittierenden Vorrichtung kann zum Beispiel eine Elektrode transparent und die andere reflektierend ausgeführt sein. Die strahlungsemittierende Vorrichtung kann somit entweder als "Bottom-Emitter" oder als "Top-Emitter" ausgeführt werden. Alternativ dazu können auch beide Elektroden transparent ausgeführt sein.

Die "erste Schichtenfolge" in der vorliegenden strahlungsemittierenden Vorrichtung ist über der ersten Elektrode angeordnet. Die erste Schichtenfolge umfasst wenigstens zwei elektromagnetische Strahlung emittierende Schichten, also zumindest eine erste Schicht die einen ersten fluoreszierenden Emitter enthält, der Strahlung in einem ersten Wellenlängenbereich emittiert, und zumindest eine zweite Schicht die einen ersten phosphoreszierenden Emitter enthält, der Strahlung in einem zweiten Wellenlängenbereich emittiert. Die Begriffe "erste" und "zweite" Schicht stellten keine Vorgabe für eine räumliche Abfolge der Schichten in der Schichtenfolge dar, sondern dienen nur der Kennzeichnung.

Die zumindest eine "erste Schicht mit einem ersten fluoreszierenden Emitter" bezeichnet eine funktionelle Schicht aus einem Matrixmaterial, das eines oder mehrere fluoreszierende Emittermaterialien umfasst.

Das fluoreszierende Emittermaterial dieser "ersten Schicht mit einem ersten fluoreszierenden Emitter" oder einer anderen Schicht mit einem fluoreszierenden Emitter kann dabei ausgewählt sein aus der Gruppe, bestehend aus BCzVBi (4,4'-Bis(9-ethyl-3-carbazovinylen)-1,1'-biphenyl), Perylen, TBPe (2,5,8,11-Tetra-tert-butylperylen), BCzVB (9H-Carbazol-3,3'-(1,4-phenylen-di-2,1-ethendiyl)bis[9-ethyl-(9C)]), DPAVBi 4,4-Bis[4-(di-p-tolylamino)styryl]biphenyl, DPAVB (4-(Di-p-tolylamino)-4'-[(di-p-tolylamino)styryl]stilben), BDAVBi (4,4'-Bis[4-(diphenylamino)styryl]biphenyl), BNP3FL (N,N'-Bis(naphthalen-2-yl)-N,N'-bis (phenyl)-tris-(9,9-dimethylfluorenylen), 9,10-Bis[(9-ethyl-3-carbazoyl)-vinylenyl]-anthracen, 4,4'-Bis(diphenylvinylenyl)-biphenyl, 1,4-Bis(9-ethyl-3-carbazovinylen)-2-methoxy-5-(2-thylhexyloxy)benzol, 4,4'-Bis(diphenylvinylenyl)-anthracen, 1,4-Bis(9-ethyl-3-carbazovinylen)-9,9-dihexyl-fluoren sowie aus Gemischen der vorgenannten Stoffe. Diese fluoreszierenden Emittermaterialien emittieren blaue Strahlung bzw. haben ihr Emissionsmaximum im blauen Spektralbereich.

Die fluoreszierenden und phosphoreszierenden Emittermaterialien können in ein Matrixmaterial eingebettet sein, das ausgewählt ist aus der Gruppe, bestehend aus MCP (1,3-Bis(carbazol-9-yl)benzol), TCP (1,3,5-Tris(carbazol)-9-yl)benzol), TcTa (4,4',4"-Tris(carbazol-9-yl)triphenylamin), CBP (4,4'-Bis(carbazol-9-yl)biphenyl), CDBP (4,4'-Bis(9-carbazolyl)-2,2'-dimethylbiphenyl), (DMFL-CBP 4,4'-Bis(carbazol-9-yl)-9,9-dimethylfluoren), FL-4CBP (4,4'-Bis(carbazol-9-yl)-9,9-bis(9-phenyl-9H-carbazol)fluoren), DPFL-CBP (4,4'-Bis(carbazol-9-yl)-9,9-ditolylfluoren), FL-2CBP (9,9-Bis(9-phenyl-9H-carbazol)fluoren), Spiro-CBP (2,2',7,7'-Tetrakis(carbazol-9-yl)-9,9'-spiro-bifluoren), ADN (9,10-Di(naphth-2-yl)anthracen, TBADN (3-Tert-butyl-9,10-di(naphth-2-yl)anthracen, DPVBi (4,4'-Bis(2,2-diphenyl-ethen-1-yl)-4,4'-dimethylphenyl), p-DMDPVBi (4,4'-Bis(2,2-diphenyl-ethen-1-yl)-4,4'-dimethylphenyl), TDAF (Tert(9,9-diarylfluoren)), BSBF (2-(9,9'-Spirobifluoren-2-yl)-9,9'-spirobifluoren), TSBF (2,7-Bis(9,9'-spirobifluoren-2-yl)-9,9'-spirobifluoren), BDAF Bis(9,9-diarylfluoren), p-TDPVBi (4,4'-Bis(2,2-diphenyl-ethen-1-yl)-4,4'-di-(tert-butyl)phenyl), TPB3 (1,3,5-Tri-(pyren-1-yl)benzol) sowie aus Gemischen der vorgenannten Stoffe. Ferner kann das Matrixmaterial n- und/oder p-dotiert sein, um zum Beispiel die Funktionalität der Schicht je nach ihrer Position in der strahlungsemittierenden Vorrichtung weiter zu fördern. Die Menge an in das Matrixmaterial eingebettetem fluoreszierendem Emittermaterial kann zum Beispiel 5 % betragen.

Die eine "zweite Schicht mit einem ersten phosphoreszierenden Emitter" bezeichnet eine funktionelle Schicht aus einem Matrixmaterial, das eines oder mehrere phosphoreszierende Emittermaterialien umfasst, welche ausschließlich Strahlung in dem selben Wellenlängenbereich emittieren.

Das phosphoreszierende Emittermaterial dieser "zweiten Schicht mit einem ersten phosphoreszierenden Emitter" oder einer anderen Schicht mit einem phosphoreszierenden Emitter kann dabei ausgewählt sein aus der Gruppe, bestehend aus Ir(ppy)₃ (Tris(2-phenylpyridin)iridium(III)), Ir(ppy)₂(acac) (Bis(2-phenylpyridin)(acetylacetonat)iridium(II)), Iridium (III)-tris(2-(4-tolyl)pyridinato-N,C2), Tris(2-phenylpyridin)iridium (III), Tris(8-hydroxychinolato)aluminium (III), Tris(2-methyl,8-hydroxychinolato)aluminium (III), Tris(8-hydroxychinolato)gallium (III), Tris(3-methyl-1-phenyl-4-trimethyl-acetyl-5-pyrazolin)terbium (III) sowie aus Gemischen der vorgenannten Stoffe. Solche Emittermaterialien emittieren grüne Strahlung bzw. haben ihr Emissionsmaximum im grünen Spektralbereich.

Alternativ dazu können die phosphoreszierenden Emittermaterialien der "Schicht mit einem phosphoreszierenden Emitter" auch ausgewählt sein aus der Gruppe, bestehend aus Eu(dbm)3(phen) (Tris(dibenzoylmethan)phenanthrolin-europium(III)), Ir(btp)₂(acac) (Bis(2-benzo[b]thiophen-2-yl-pyridin) (acetylacetonat)iridium(III)), Ir(piq)₂(acac) (Bis(1-phenylisochinolin)(acetylacetonat)iridium(III)), Ir(fliq)₂(acac)-1 (Bis[1-(9,9-dimethyl-9H-fluoren-2-yl)-isochinolin] (acetylacetonat)iridium(III)), Ir(flq)₂(acac)-2 (Bis[3-(9,9-dimethyl-9H-fluoren-2-yl)-isochinolin](acetylacetonat)iridium(III)), Ru(dtb-bpy)₃*2(PF₆) (Tris[4,4'-di-tert-butyl-(2,2')-bipyridin]ruthenium(III)komplex), Ir(2-phq)₃ (Tris(2-phenylchinolin)iridium(III)), Ir(2-phq)₂(acac) (Bis(2-phenylchinolin)(acetylacetonat)iridium(III)), Ir(piq)₃ (Tris-(1-phenylisochinolin)iridium(III)), Iridium (III)-bis(2-(2'-benzothienyl)pyridinato-N,C3') (acetylacetonat), Tris(dibenzoylacetonato)-mono(phenanthrolin)-europium (III), Tris(dibenzoylmethan)-mono(phenanthrolin)-europium (III), Tris(dibenzoylmethan)-mono(5-aminophenanthrolin)-europium (III), Tris(dinaphthoylmethan)-mono(phenanthrolin)-europium (III), Tris(4-brombenzoylmethan)-mono(phenanthrolin)-europium (III), Tris(dibiphenoylmethan)-mono(phenanthrolin)-europium (III), Tris(dibenzoylmethan)-mono(4,7-dimethylphenanthrolin)-europium (III), Tris(dibenzoylmethan)-mono(4,7-dimethylphenanthrolin-disulfonsäure)-europium (III)-dinatriumsalz, Tris[di(4-(2-(2-thoxyethoxy)ethoxy)benzoyl-methan)]-mono(phenanthrolin)-europium (III), Tris[di(4-(2-(2-thoxyethoxy)ethoxy)benzoylmethan)]-mono(5-aminophenanthrolin)-europium (III) sowie aus Gemischen der vorgenannten Stoffe. Solche Emittermaterialien emittieren rote Strahlung bzw. haben ihr Emissionsmaximum im roten Spektralbereich.

Ferner können die phosphoreszierenden Emitter der "Schicht mit einem phosphoreszierenden Emitter" auch ausgewählt sein aus der Gruppe, bestehend aus FlrPic (Bis(3,5-difluoro-2-(2-pyridyl)phenyl-(2-carboxypyridyl)-iridium III), Flr6 (Bis(48,68-difluorophenylpyridinato)-tetrakis(1-pyrazolyl)borat-iridium III) sowie aus Gemischen der vorgenannten Stoffe. Solche Emittermaterialien emittieren blaue Strahlung bzw. haben ihr Emissionsmaximum im blauen Spektralbereich.

Durch Verwendung eines im blauen Spektralbereich emittierenden phosphoreszierenden Emitters in Kombination mit einem im blauen Spektralbereich emittierenden fluoreszierenden Emitter kann der Blauanteil in der emittierten Gesamtstrahlung erhöht werden, was zum Beispiel zur Erzeugung eines kälteren Weißlichts verwendet werden kann.

Auch die phosphoreszierenden Emittermaterialien können in die vorstehend genannten Matrixmaterial eingebettet sein. Die Menge an in das Matrixmaterial eingebettetem phosphoreszierendem Emittermaterial kann zum Beispiel 4 % oder 5 % betragen.

Die erfindungsgemäßen Schichten mit fluoreszierenden oder phosphoreszierenden Emittern können durch gleichzeitiges Abscheiden des Matrixmaterials und des Emittermaterials gebildet werden. Zum Beispiel werden hierfür jeweils eine Quelle mit Matrixmaterial und eine Quelle mit Emittermaterial mit dem gewünschten Anteil an Emittermaterial aufeinander eingeregelt und im Folgenden mit einer bestimmten Abscheiderate und für eine bestimmte Abscheidedauer auf einer Schicht abgeschieden. So kann eine Schicht mit Emittermaterial mit einer gewünschten Dicke und den gewünschten funktionalen Eigenschaften, wie beispielsweise einer n- und/oder p-Dotierung in der strahlungsemittierenden Vorrichtung erhalten werden.

Die "zweite Schichtenfolge" ist zwischen der ersten und der zweiten Elektrode angeordnet. Sie umfasst zumindest eine erste Schicht mit einem zweiten fluoreszierenden Emitter, der Strahlung in dem ersten Wellenlängenbereich emittiert, und zumindest eine zweite Schicht mit einem zweiten phosphoreszierenden Emitter, der Strahlung in dem dritten Wellenlängenbereich emittiert.

Für den Aufbau und die Ausführung der Schichten der zweiten Schichtenfolge gelten die gleichen Definitionen wie sie vorstehend für die erste Schichtenfolge beschrieben wurden. Die erste Schicht der ersten Schichtenfolge und die erste Schicht der weiteren Schichtenfolge(n) können hierbei gleich oder verschieden sein. Entsprechendes gilt für die zweite und jede weitere Schicht der Schichtenfolgen

Die strahlungsemittierende Vorrichtung kann ferner weitere Schichtenfolgen umfassen, deren Aufbau und Ausführung analog der ersten und zweiten Schichtenfolge erfolgen kann.

Erfindungsgemäß sollen, soweit nicht anders angegeben, alle für die erste Schichtenfolge der strahlungsemittierenden Vorrichtung beschriebenen Ausführungen analog für die zweite Schichtenfolge und/oder weitere Schichtenfolgen gelten.

Mit der strahlungsemittierenden Vorrichtung der vorliegenden Erfindung ist es in vorteilhafter Weise möglich, eine verbesserte Ausbeute der emittierten Strahlung und damit eine verbesserte Funktionalität und Effizienz bereitzustellen. Durch geeignete Auswahl der fluoreszierenden und phosphoreszierenden Emittermaterialien in den strahlungsemittierenden Schichten der Schichtenfolgen können verschiedene Farbeindrücke der von der strahlungsemittierenden Vorrichtung emittierten Gesamtstrahlung erzielt werden und somit können zum Beispiel gezielt Alterungserscheinungen einzelner Schichtenfolgen der strahlungsemittierenden Vorrichtung kompensiert werden. So ist es in vorteilhafter Weise möglich, die Effizienz, Beständigkeit und Lebensdauer der strahlungsemittierenden Vorrichtung weiter zu verbessern. Dies erhöht gleichermaßen die wirtschaftliche Rentabilität der strahlungsemittierenden Vorrichtung und begünstigt eine großtechnische Herstellung derselben.

In einer weiteren Ausführungsform der vorliegenden Erfindung werden Singulett- und Triplett-Exzitonen nur in der jeweils ersten Schicht einer Schichtenfolge erzeugt.

Mit "Singulett-Exzitonen" sind hierbei die zu Fluoreszenz führenden Exzitonen und mit "Triplett-Exzitonen" die zu Phosphoreszenz führenden Exzitonen bezeichnet, die infolge der statistischen Wahrscheinlichkeit ihrer Bildung zu einem Verhältnis von Fluoreszenz zu Phosphoreszenz von 25 % zu 75 % führen.

Wenn die Exzitonen im Wesentlichen nur in den jeweils ersten Schichten gebildet werden, können die Singulett-Exzitonen das in der ersten Schicht vorhandene fluoreszierende Emittermaterial anregen, die Triplett-Exzitonen können mittels Energietransfermechanismen in die Schichten mit dem jeweiligen phosphoreszierenden Emitter übertragen werden und dort gezielt die vorhandenen phosphoreszierenden Emitter anregen. Durch die gezielte Ausnutzung der Exzitonen in den entsprechenden Schichten können die Verluste an Exzitonen und damit Energieverluste während des Betriebs der strahlungsemittierenden Vorrichtung verringert werden und eine deutlich höhere Strahlungsausbeute erzielt werden, als es mit Singulett-Emittern und Triplett-Emittern allein möglich ist. Die räumliche Trennung der Singulett- und Triplett-Emitter sorgt zusätzlich dafür, dass zwischen den beiden Systemen keine strahlungslosen Quenchvorgänge möglich sind.

Eine derartige Ausführung einer erfindungsgemäßen strahlungsemittierenden Vorrichtung kann also dazu beitragen, die Effizienz der strahlungsemittierenden Vorrichtung insgesamt zu verbessern. Durch die gezielte Ausnutzung der Exzitonen in den jeweiligen Schichten kann auch die Wärmestrahlung verringert und die Lebensdauer der strahlungsemittierenden Vorrichtung verbessert werden.

Die erste Schichtenfolge der strahlungsemittierenden Vorrichtung gemäß der vorliegenden Erfindung umfasst eine dritte Schicht mit einem fluoreszierenden Emitter.

Der fluoreszierende Emitter kann dabei aus der vorstehend angegebenen Liste der fluoreszierenden Emittermaterialien ausgewählt sein. Die Ausbildung dieser dritten Schicht kann derjenigen der vorstehend beschriebenen ersten Schicht entsprechen.

Bei einer solchen strahlungsemittierenden Vorrichtung kann der Anteil an fluoreszierender Strahlung in der Gesamtstrahlung der strahlungsemittierenden Vorrichtung verdoppelt werden.

In einer weiteren Ausführungsform der vorliegenden Erfindung weist die strahlungsemittierende Vorrichtung zwischen der ersten Schicht und der zweiten Schicht einer Schichtenfolge eine Blockierschicht auf. Zusätzlich ist eine solche Blockierschicht auch zwischen der zweiten Schicht und der dritten Schicht einer Schichtenfolge angeordnet.

Eine solche Blockierschicht kann zum Blockieren von Singulett-Exzitonen dienen und dabei so gestaltet sein, dass ihre Dicke größer ist als die mittlere freie Weglänge der in der ersten Schicht gebildeten Singulett-Exzitonen, so dass diese im Wesentlichen nicht in die zweite Schicht gelangen können. Eine solche Blockierschicht kann daher zum selektiven Blockieren von Singulett-Exzitonen dienen. Sie kann ein Matrixmaterial umfassen oder hieraus bestehen, wobei geeignete Matrixmaterialen aus den vorstehend offenbarten Matrixmaterialien ausgewählt sind.

Bei einer derart ausgeführten strahlungsemittierenden Vorrichtung kann die Effizienz unter Ausnutzung und Steuerung des Singulett-Triplett-Managements zwischen den fluoreszierenden und den phosphoreszierenden Schichten weiter verbessert und die Gesamtausbeute an emittierter Strahlung erhöht werden.

Des Weiteren können solche Blockierschichten in Ausführungsvarianten mit drei oder mehr Schichtenfolgen zwischen jeweils zwei strahlungsemittierenden Schichten angeordnet sein.

In einer Ausführungsform kann die Zwischenschicht eine loch- und elektronenleitende organische Schicht und/oder eine Metallschicht und/oder eine Metalloxidschicht aufweisen.

Es ist zum Beispiel möglich, Metallfilme, wie Gold-, Silberfilme, Oxidfilme, wie beispielsweise MoO₃ und/oder p- und n-dotierte Doppelschichten, wie beispielsweise eine Doppelschicht aus einem dotierten organischen Film zu verwenden.

Eine n-dotierte Schicht kann zum Beispiel mit Li dotiertes Alq oder mit Li dotiertes TPBI umfassen, eine p-dotierte Schicht kann zum Beispiel mit FeCl₃ dotiertes NPB umfassen.

In einer weiteren Ausführungsform der strahlungsemittierenden Vorrichtung ist die Zwischenschicht zwischen den Schichtenfolgen sowohl loch- als auch elektronenleitend.

Das bedeutet, dass die Zwischenschicht sowohl n- als auch p-dotiert ist.

Geeignete p-Dotanten umfassen F₄-TCNQ (2,3,5,6-Tetrafluoro-7,7,8,8-tetracyanochinodimethan) und verwandte Verbindungen des Naphthalins und dessen höheren Homologen, aber auch Übergangsmetalloxide wie MoO₃, WO₃, V₂O₅, usw. (sowie Kombinationen aller vorgenannten Verbindungen. Diese p-Dotanten liegen bevorzugt in den Matrixmaterialien NPD und 2T-NATA vor.

Geeignete n-Dotanten umfassen zum Beispiel Alkali- und Erdalkalimetalle und Lanthanoide (wie Li, Na, K, Cs, Mg, Ca, Sr, Ba, Yb) für phenanthrolin-basierte Matrixmaterialien. Ferner können auch Salze und metallorganischen Verbindungen wie CsCO₃, Ca(acac)₂, sowie Kombinationen davon sowie eine bevorzugt kathodenseitig angeordnete LiF-Schicht zwischen den beiden Elektroden verwendet werden.

Mit einer derartigen Ausgestaltung kann die Effizienz der strahlungsemittierenden Vorrichtung, die auf dem Aufeinandertreffen von Elektronen und Löchern in den geeigneten strahlungsemittierenden Schichten und deren Rekombination basiert, weiter verbessert werden.

Da die Zwischenschicht zum Beispiel als ladungserzeugende Schicht (als sogenannter Charge-Generation-Layer) ausgebildet sein kann, kann sie in vorteilhafter Weise eine weitere Spannungsversorgung bereitstellen. Die als eine Art "Doppelelektrode" fungierende Zwischenschicht kann dann kathodenseitig die Funktion einer Anode für die zwischen der Kathode und der Zwischenschicht liegende Schichtenfolge und anodenseitig die Funktion einer Kathode für die zwischen der Anode und der Zwischenschicht liegende Schichtenfolge ausüben. Somit können die einzelnen Schichtenfolgen gezielt angesteuert werden. Die zwischen den beiden Elektroden im Betrieb der strahlungsemittierenden Vorrichtung angelegte Spannung kann dabei variabel auf die beiden Schichtenfolgen, gegebenenfalls auch auf nur eine Schichtenfolge verteilt werden. Die Verteilung kann hierbei auch während des Betriebs der strahlungsemittierenden Vorrichtung geändert werden.

Durch eine derartige gezielte Ansteuerung können Alterungserscheinungen der strahlungsemittierenden Vorrichtung kompensiert und die Effizienz der strahlungsemittierenden Vorrichtung weiter verbessert werden. Durch individuelles Einstellen der von den einzelnen Schichtenfolgen emittierten Strahlung kann ferner eine hohe Variabilität der strahlungsemittierenden Vorrichtung geboten und die wirtschaftliche Rentabilität weiter gesteigert werden.

In einer weiteren Ausgestaltung sind die erste Schicht der ersten Schichtenfolge und die erste Schicht der zweiten Schichtenfolge identisch.

Identisch bedeutet hierbei, dass die beiden Schichten gleich aufgebaut sind und die gleiche Zusammensetzung aufweisen. Eine solche Ausgestaltung der strahlungsemittierenden Vorrichtung kann die Herstellbarkeit der strahlungsemittierenden Vorrichtung erleichtern und damit zur wirtschaftlichen Rentabilität derselben beitragen.

Daneben können beispielsweise auch die jeweils dritten Schichten einer Schichtenfolge identisch sein.

Die strahlungsemittierende Vorrichtung emittiert Weißlicht, das durch eine Überlagerung der Strahlung des ersten, des zweiten und des dritten Wellenlängenbereichs entsteht.

Das emittierte Weißlicht kann dabei auch "kaltes" oder "warmes" Weiß sein, wie es allgemein gemäß dem CIE-Farbdiagramm definiert ist.

Zum Beispiel kann eine strahlungsemittierende Vorrichtung, die Weißlicht erzeugt, dadurch erhalten werden, dass ein blau fluoreszierendes Emittermaterial in der jeweils ersten und dritten Schicht der jeweils ersten und zweiten Schichtenfolge und ein grün phosphoreszierendes Emittermaterial in der zweiten Schicht der ersten Schichtenfolge und ein rot phosphoreszierendes Emittermaterial in der zweiten Schicht der zweiten Schichtenfolge angeordnet werden. Daneben kann zum Beispiel mit einem blau fluoreszierenden Emittermaterial in Kombination mit einem rot-orange phosphoreszierenden Emittermaterial Weißlicht erzeugt werden.

Die strahlungsemittierende Vorrichtung kann auch weitere funktionelle Schichten aufweisen. Solche Schichten können beispielsweise Elektronentransportschichten, Elektroneninjektionsschichten, Lochtransportschichten und/oder Lochinjektionsschichten sein. Solche Schichten können dazu dienen, die Effizienz der strahlungsemittierenden Vorrichtung weiter zu steigern und an einer oder mehreren geeigneten Stellen der strahlungsemittierenden Vorrichtung ausgebildet werden. Sie können geeignete Elektronentransportmaterialien und/oder Lochtransportmaterialien und/oder zur Verbesserung der Lochinjektion geeignete Materialien umfassen.

Als Elektronentransportmaterialien seien beispielsweise Liq (8-Hydroxychinolinolato-lithium), TPBi (2,2',2"-(1,3,5-Benzintriyl)-tris(1-phenyl-1-H-benzimidazol)), PBD (2-(4-Biphenylyl)-5-(4-tert-butylphenyl)), BCP (2,9-Dimethyl-4,7-diphenyl-1,10-phenanthrolin), BPhen (4,7-Diphenyl-1,10-phenanthrolin), BAlq (Bis-(2-methyl-8-chinolinolat)-4-(phenylphenolato)aluminium) sowie Gemische der vorgenannten Stoffe genannt.

Als Lochtransportmaterialien seien zum Beispiel NPB (N,N'-Bis(naphthalen-1-yl)-N,N'-bis(phenyl)-benzidin, β-NPB (N,N'-Bis(naphthalen-2-yl)-N,N'-bis(phenyl)-benzidin), TPD (N,N'-Bis(3-methylphenyl)-N,N'-bis(phenyl)-benzidin), Spiro-TPD (N,N'-Bis(3-methylphenyl)-N,N'-bis(phenyl)-benzidin), Spiro-NPB (N,N'-Bis(naphthalen-1-yl)-N,N'-bis(phenyl)-spiro), DMFL-TPD (N,N'-Bis(3-methylphenyl)-N,N'-bis(phenyl)-9,9-dimethylfluoren, DMFL-NPB (N,N'-Bis(naphthalen-1-yl)-N,N'-bis(phenyl)-9,9-dimethylfluoren), DPFL-TPD (N,N'-Bis(3-methylphenyl)-N,N'-bis(phenyl)-9,9-diphenylfluoren), DPFL-NPB (N,N'-Bis(naphthalen-1-yl)-N,N'-bis(phenyl)-9,9-diphenylfluoren), Spiro-TAD (2,2',7,7'-Tetrakis(n,n-diphenylamino)-9,9'-spirobifluoren) oder Gemische der vorgenannten Stoffe genannt.

Als zur Verbesserung der Lochinjektion geeignete Materialien, seien beispielsweise CuPC (Phthalocyanin, Kupferkomplex), TiOPC (Titanoxidphthalocyanin), m-MTDATA (4,4',4''-Tris(N-3-methylphenyl-N-phenylamino)triphenylamin), 2T-NATA (4,4',4"-Tris(N-(2-naphthyl)-N-phenyl-amino)triphenylamin), IT-NATA (4,4',4"-Tris(N-(1-naphthyl)-N-phenylamino)triphenylamin), NATA (4,4',4"-Tris(N,N-diphenylamino)triphenylamin) sowie Gemische der vorgenannten Stoffe genannt, wobei die angegebenen Materialien optional dotiert sein können.

Daneben können einzelne funktionelle Schichten der strahlungsemittierenden Vorrichtung aus mehreren dünnen Schichten aufgebaut sein.

Optional ist es auch möglich, das Substrat und/oder zumindest eine Elektrode so zu strukturieren, dass die strahlungsemittierende Vorrichtung Muster abstrahlt.

Zusammenfassend kann eine strahlungsemittierende Vorrichtung gemäß der vorstehend beschriebenen dem ersten Ausführungsbeispiel eine verbesserte Ausbeute an emittierter Strahlung bereitstellen. Da der Anteil an fluoreszierender Strahlung erhöht werden kann, ist die Erzeugung eines "kälteren" Weißlichts möglich. Daneben können mögliche Alterungserscheinungen in vorteilhafter Weise kompensiert werden. Eine derartige strahlungsemittierende Vorrichtung kann bessere Flächeneffizienzen erreichen und somit zu einer erhöhten Effizienz der strahlungsemittierenden Vorrichtung beitragen. Die Haltbarkeit und Beständigkeit können in vorteilhafter Weise verbessert und damit die wirtschaftliche Rentabilität der strahlungsemittierenden Vorrichtung gefördert werden.

Eine bevorzugte Ausführungsvariante einer strahlungsemittierenden Vorrichtung gemäß der vorliegenden Erfindung ist zum Beispiel als organische Leuchtdiode (= OLED) ausgeführt.

Im Folgenden wird die vorliegende Erfindung anhand von Ausbildungsformen unter Bezugnahme auf die beigefügten Figuren beschrieben.

In den Figuren werden gleiche Bezugszeichen zur Bezeichnung gleicher Elemente verwendet. Die Beispiele dienen lediglich zur Veranschaulichung der Erfindung und sollen diese in keinster Weise einschränken.

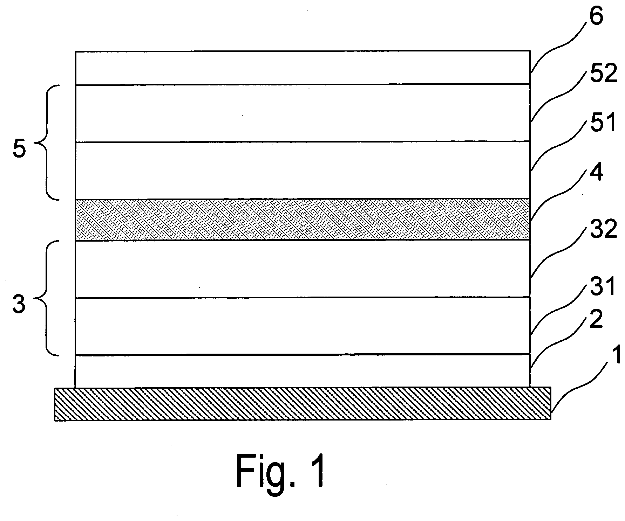

Die Figuren 1, 2 und 4 zeigen schematisch eine Übersicht über eine strahlungsemittierende Vorrichtung gemäß je einem Vergleichsbeispiel und die 3 zeigt schematisch eine Übersicht über eine strahlungsemittierende Vorrichtung gemäß einer Ausführungsform der vorliegenden Erfindung.

Eine strahlungsemittierende Vorrichtung gemäß Figur 1 (nicht Teil der beanspruchten Erfindung), umfasst ein Substrat 1, eine erste Elektrode 2, eine erste Schichtenfolge 3 mit einer ersten Schicht mit einem ersten fluoreszierendem Emitter 31 und einer zweiten Schicht mit einem ersten phosphoreszierenden Emitter 32, eine Zwischenschicht 4, eine zweite Schichtenfolge 5 mit einer ersten Schicht mit einem zweiten fluoreszierenden Emitter 51 und einer zweiten Schicht mit einem zweiten phosphoreszierenden Emitter 52 und eine zweite Elektrode 6.

Das Substrat 1 kann ein Glassubstrat sein. Die erste Elektrode 2, die zum Beispiel als Anode ausgebildet ist, kann eine Schicht aus ITO sein und unmittelbar auf dem Substrat 1 angeordnet sein. Die auf der ersten Elektrode 2 angeordnete erste Schichtenfolge 3 kann zum Beispiel eine erste Schicht 31 mit einem blau fluoreszierenden Emitter und eine zweite Schicht 32 mit einen grün phosphoreszierenden Emitter umfassen. Dabei kann die erste Schicht 31 durch Einbetten von 5 % BCzVBi in CBP gebildet sein, die zweite Schicht 32 kann durch Einbetten von 5 % Ir(ppy)₃ in CBP gebildet sein. Auf der zweiten Schicht 32 der ersten Schichtenfolge 3 kann eine als Charge-Generation-Layer ausgebildete Zwischenschicht 4 abgeschieden sein. Dafür kann eine Goldschicht, die selektiv aus der strahlungsemittierenden Vorrichtung herausgeführt wird und mit einer separaten Spannungsquelle versehen ist, verwendet werden. Eine zweite Schichtenfolge 5 ist auf der Zwischenschicht 4 angeordnet. Die zweite Schichtenfolge 5 kann dabei eine erste Schicht mit einem zweiten fluoreszierenden Emitter 51 sowie eine zweite Schicht mit einem zweiten phosphoreszierenden Emitter 52 umfassen, die aus einem zweiten blau fluoreszierenden Emitter und einem zweiten rot phosphoreszierenden Emitter gebildet sind. Zu diesem Zweck eignet sich die Verwendung einer CBP-Schicht mit 5 % BCzVBi als blau fluoreszierende Schicht 51 und die Verwendung einer mit 4 % PQIr dotierten CMP-Schicht als rot phosphoreszierende Schicht 52.

Auf die zweite Schicht 52 der zweiten Schichtenfolge kann die zweite Elektrode 6 aufgebracht sein, die zum Beispiel als Kathode ausgebildet ist. Eine solche Kathodenschicht 6 kann zum Beispiel eine Aluminiumschicht sein. Eine solche Aluminiumschicht bildet eine reflektierende Schicht für einen Bottom-Emitter.

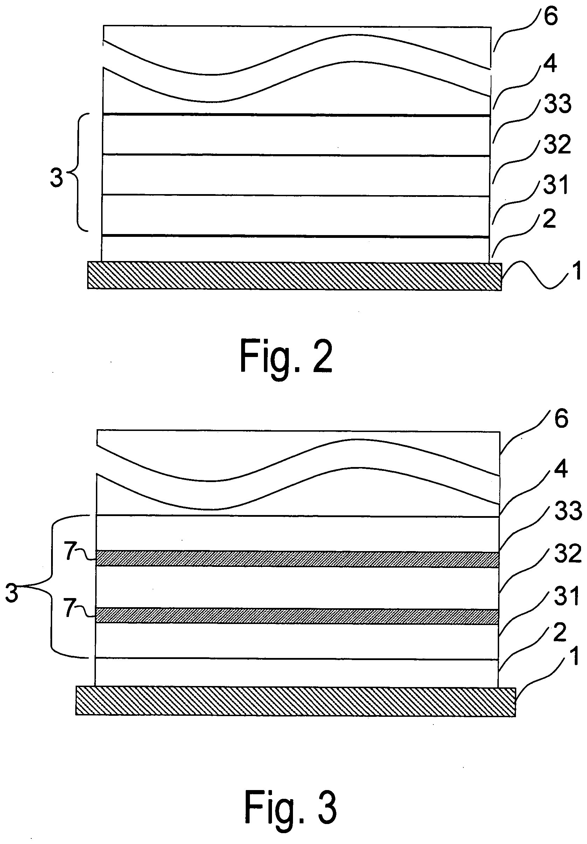

In Figur 2 (nicht Teil der beanspruchten Erfindung) ist in der strahlungsemittierenden Vorrichtung eine dritte Schicht 33 vorgesehen, die als fluoreszierende Strahlung emittierende Schicht ausgebildet ist. Eine geeignete dritte Schicht ist beispielsweise eine mit 5 % BCzVBi dotierte CBP-Schicht.

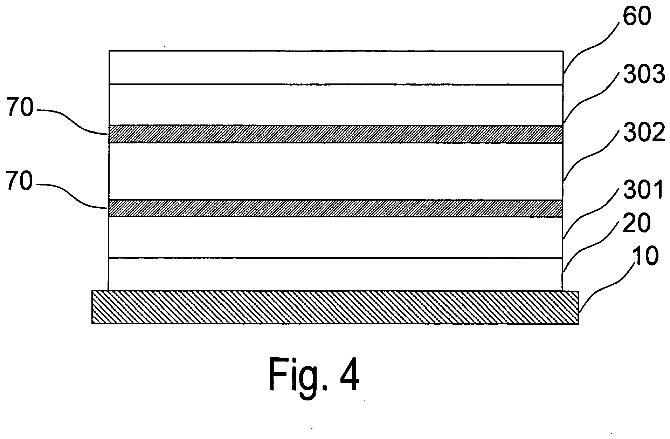

Die doppelte Wellenlinie in Fig. 2 soll das Vorhandensein weiterer Schichten und/oder Schichtenfolgen kennzeichnen. Neben den vorstehend beschriebenen Elementen zeigt Figur 3 zusätzlich zwei Blockierschichten 7, die jeweils zwischen der ersten Schicht 31 und der zweiten Schicht 32 und der zweiten Schicht 32 und der dritten Schicht 33 der ersten Schichtenfolge 3 angeordnet sind. Eine solche Blockierschicht ist zum Beispiel eine 10 nm dicke, nicht dotierte CBP-Schicht. Figur 4 zeigt eine strahlungsemittierende Vorrichtung mit einem Substrat 10, einer ersten Elektrode 20, einer ersten Schicht mit einem ersten fluoreszierenden Emitter 301, einer zweiten Schicht mit einem phosphoreszierenden Emitter 302, einer dritten Schicht mit einem zweiten fluoreszierenden Emitter 303, Blockierschichten 70 und eine zweite Elektrode 60. Die erste Schicht 301 und die dritte Schicht 303 können Schichten mit blau fluoreszierenden Emittern und die zweite Schicht 302 eine Schicht mit rot-orange phosphoreszierendem Emitter sein.

Nach der allgemeinen Beschreibung der Figuren wird die Erfindung im Folgenden ohne Einschränkung der Allgemeinheit anhand von Beispielen noch näher erläutert.

### Beispiel 1 - allgemeine Herstellungsbedingungen

In einem Vakuumrezipienten sind 10 Quellen eingebaut, in denen organisches Material bis zu einer Temperatur von 450 °C verdampft werden kann. Die Quellen werden dabei indirekt über eine Konstantanwicklung geheizt. Die Quelle selbst besteht jeweils aus einem unten verschlossenen Quarzrohr oder aus einem Al₂O₃-Tiegel. Die Temperatur der Quelle wird über einen PID-Regler kontrolliert. Die abgedampfte Substanzmenge wird mit Hilfe eines Schwingquarzes verfolgt, der dabei als Schichtdickenmonitor dient. Die Kalibrierung erfolgt durch Abscheidung einer Referenzschicht. Als Korrekturfaktor dient der Quotient aus der Anzeige des Schichtdickenmonitors (Schwingquarz) und der über ein Profilometer bestimmten tatsächlich abgeschiedenen Schicht.

Zur Abscheidung der Schichten wird ein Substrathalter in 35 cm Entfernung von den kreisförmig angeordneten Quellen angebracht. Der Substrathalter dient hierbei als Quelle für die Zuführung des Matrixmaterials. Das Substrat kann dabei mit Hilfe einer Substratblende von den einzelnen Quellen abgetrennt werden. Die einzelnen Quellen enthalten dabei die fluoreszierenden oder phosphoreszierenden Emittermaterialien oder p- oder n-Dotanten zur Herstellung der einzelnen funktionellen Schichten der strahlungsemittierenden Vorrichtung. Die Abtrennung des Substrats von den jeweiligen Quellen dient zur Einstellung der jeweiligen Dampfraten. Sobald sich die Quellen stabilisiert haben, wird die Substratblende geöffnet und die eigentliche Abscheidung der Schichten beginnt.

Die in den folgenden Beispielen verwendeten Abscheideraten sind in Tabelle 1 zusammengefasst.

**Tabelle 1**

| Substanz | Abscheiderate |
|---|---|
| | [nm/s] |
| NPB | 0,1 |
| CBP | 0,1 |
| BCP | 0,1 |
| BCzVBi | 0,005 |
| PQIr | 0,004 |
| Ir(ppy)₃ | 0,005 |
| CsCO₃ | 0,02 |
| N-TATA | 0,1 |
| MoO₃ | 0,05 |
| F₄-TCNQ | 0,008 |

### Beispiel 2:

Mittels HF-Sputtern (500 W, 50 sccm Ar, 5 sccm O₂) wird eine 100 nm dicke Indium-Zinn-Oxid-(ITO-)Schicht als Anode auf einer Glasplatte abgeschieden. Die ITO-Schicht wird anschließend mittels i-line-Lithographie und Nassätzung strukturiert. Zur Abscheidung der weiteren funktionellen Schichten wird das Substrat in den vorstehend beschriebenen Rezepienten eingebracht.

Zur Ausbildung einer Lochinjektionsschicht wird eine NPB-Quelle für das Matrixmaterial und eine F4TCNQ-Quelle als p-Dotant auf die Abscheideraten gemäß Tabelle 1 eingestellt. Während des Einstellens bleibt die Substratblende geschlossen. Durch Öffnen der Substratblende wird eine 40 nm dicke Lochinjektionsschicht aus NTB, dotiert mit 8 % F4TCNQ, in 340 sec auf der ITO-Schicht abgeschieden. Zur Abscheidung der Lochtransportschicht wird die F₄TCNQ-Quelle abgeschaltet und dann eine 20 nm dicke, undotierte NTB-Schicht auf der Lochinjektionsschicht abgeschieden. Anschließend wird die NTB-Quelle abgekühlt und die CBP-(Matrix) BCzVBi-(blauer fluoreszierender Emitter) Quellen werden bei geschlossener Substratblende eingeregelt. Durch Öffnen der Substratblende wird innerhalb von 95 sec eine 10 nm dicke CBP-Schicht, die mit 5 % BCzVBi dotiert ist, als erste Schicht mit einem ersten fluoreszierenden Emitter abgeschieden. Die Abscheidung aller weiteren Schichten erfolgt analog mit den jeweiligen in Tabelle 1 angegebenen Abscheideraten. Auf die erste Schicht mit fluoreszierendem Emitter wird eine 10 nm dicke, nicht dotierte CBP-Schicht als Blockierschicht abgeschieden. Eine grün phosphoreszierende Schicht wird als 8 nm dicke CBP-Schicht, dotiert mit 5 % Ir(ppy)₃ gebildet. Anschließen werden 6 nm CBP als Blockierschicht abgeschieden. Die dritte Schicht mit einem zweiten fluoreszierenden Emitter wird aus 10 nm CBP, dotiert mit 5 % BCzVBi, gebildet. Eine 20 nm dicke BCP-Schicht bildet eine Elektronentransportschicht. Die Zwischenschicht wird dann in Form einer Charge-Generation-Layer aus einer 8 nm dicken Goldschicht gebildet. Dabei wird die Goldschicht selektiv aus der strahlungsemittierenden Vorrichtung herausgeführt und mit einer externen Spannungsquelle verbunden. Als Lochinjektions- beziehungsweise Lochtransportschicht werden 20 nm NPB mit 8 % F₄TCNQ, gefolgt von 20 nm nativem NPB aufgetragen. Als weitere strahlungsemittierende Schicht folgt eine 10 nm dicke CBP-Schicht, die mit 5 % BCzVBi dotiert ist. Als Blockierschicht ist eine 10 nm dicke CBP-Schicht vorgesehen. Die zweite Schicht mit einem zweiten phosphoreszierenden Emitter wird durch eine 8 nm dicke CMP-Schicht, die mit 4 % PQIr als rotem Emitter dotiert ist, gebildet. Auf eine 6 nm CBP-Blockierschicht folgt eine 10 nm dicke CBP-Schicht mit 5 % BCzVBi als dritte strahlungsemittierende Schicht. Dann wird eine 20 nm dicke BCP-Schicht als Elektronentransportschicht abgeschieden. 30 nm BCP mit 20 % CsCO₃ n-dotiert dienen als Elektroneninjektionsschicht. Darauf folgt eine 0,6 nm dicke LiF-Schicht, bevor eine 150 nm dicke Aluminiumschicht als reflektive Elektrode gebildet wird.

Die nachfolgende Tabelle 2 fasst die im Beispiel 2 angegebenen Schichten zusammen.

**Tabelle 2**

| Schicht | Schichtdicke [nm] | Matrixmaterial | Dotant |
|---|---|---|---|
| Substrat | | -- | -- |
| Anode | 100 | ITO | -- |
| Lochinjektionsschicht | 40 | NPB | 8 % F₄-TCNQ |
| Lochtransportschicht | 20 | NPB | -- |
| Erste blau fluoreszierende Schicht | 10 | CBP | 5 % BczVBi |
| Blockierschicht | 10 | CBP | -- |
| Grün phosphoreszierende Schicht | 8 | CBP | 5 % Ir(ppy)₃ |
| Blockierschicht | 6 | CBP | -- |
| Zweite blau fluoreszierende Schicht | 10 | CBP | 5 % BCzVBi |
| Elektronentransportschicht | 20 | BCP | -- |
| Charge-Generation-Layer (Zwischenschicht) | 8 | Au | -- |
| Lochinjektions-/ | 20 | NPB | 8 % F₄-TCNQ |
| Lochtransportschicht | 20 | NPB | -- |
| Dritte blau fluoreszierende Schicht | 10 | CBP | 5 % BCzVBi |
| Blockierschicht | 10 | CBP | -- |
| Rot phosphoreszierende Schicht | 8 | CBP | 4 % PQIr |
| Blockierschicht | 6 | CBP | -- |
| Vierte blau fluoreszierende Schicht | 10 | CBP | 5 % BCzVBi |
| Elektronentransportschicht | 20 | BCP | -- |
| Elektroneninjektionsschicht | 30 | BCP | 20 % CsCO₃ |
| "Ionensperrschicht" | 0, 6 | LiF | -- |
| Kathode | 150 | Al | -- |

### Beispiel 3

Die strahlungsemittierende Vorrichtung wird analog Beispiel 1 ausgeführt, außer dass die Reihenfolge der Abscheidung des roten und grünen phosphoreszierenden Emitters vertauscht ist.

### Beispiel 4

Die strahlungsemittierende Vorrichtung wird analog Beispiel 2 ausgeführt, außer dass der blau phosphoreszierende Emitter in der jeweils ersten Schicht der Schichtenfolgen DPAVB ist.

### Beispiel 5

Die strahlungsemittierende Vorrichtung wird analog Beispiel 3 ausgeführt, außer dass statt DPAVB das im tieferen Blau emittierende BDAVBi verwendet wird.

### Beispiel 6

Die strahlungsemittierende Vorrichtung wird analog Beispiel 1 ausgeführt, außer dass anstelle einer Goldschicht als Charge-Generation-Layer zwei Schichten aus mit Li-dotiertem BPhen und mit F₄TCNQ dotiertem NBP verwendet wird.

### Beispiel 7

Die strahlungsemittierende Vorrichtung wird wie in Beispiel 5 ausgeführt, außer dass BPhen mit Cäsium dotiert ist.

### Beispiel 8

Die strahlungsemittierende Vorrichtung wird wie in Beispiel 5 ausgeführt, außer dass die Charge-Generation-Layer aus einer Schicht aus mit 20 % CsCO₃ dotiertem BCP und einer Schicht aus mit 45 % MoO₃ dotiertem NBP gebildet wird.

### Beispiel 9 (nicht Teil der beanspruchten Erfindung)

Die strahlungsemittierende Vorrichtung wird wie in Beispiel 1 ausgeführt, außer dass der erste und der zweite phosphoreszierende Emitter jeweils als orange/gelber Emitter mit Bis-(8-Hydroxichinolinato)-zink als Emittermaterial ausgebildet sind.

### Beispiel 10

Die strahlungsemittierende Vorrichtung wird wie in Beispiel 1 ausgeführt, außer dass statt CBP CPF als Matrixmaterialien in den Schichten verwendet wird.

### Beispiel 11

Die strahlungsemittierende Vorrichtung wird wie in Beispiel 1 ausgeführt, außer dass auf der elektroneninjizierenden Seite statt BCP als Matrixmaterial TAZ und/oder TPBi verwendet werden und auf der lochinjizierenden Seite TCTA und/oder NPB verwendet wird.

### Beispiel 12

Zur Einstellung eines gewünschten Farborts und der Effizienz der strahlungsemittierenden Vorrichtung werden alle in Beispiel 1 diskutierten und in Tabelle 2 angegebenen Schichtdicken und Dotierstoffkonzentrationen einem so genannten "Design-off-Experiment"-Prozess unterzogen und zur Optimierung der erhaltenen Ergebnisse entsprechend variiert. Die Ausführungsbeispiele der vorliegenden Erfindung können beliebig weiter variiert werden im Einklang mit der beanspruchten Erfindung gemäß Anspruch 1. Es ist weiterhin zu berücksichtigen, dass sich die Erfindung nicht auf diese Beispiele beschränkt, sondern weitere, hier nicht aufgeführte Ausgestaltungen zulässt.

## Patentansprüche

1. Strahlungsemittierende Vorrichtung zum Emittieren elektromagnetischer Strahlung, die eine Mischung von zumindest drei verschiedenen Teilstrahlungen eines ersten, eines zweiten und eines dritten Wellenlängenbereichs umfasst, wobei durch eine Überlagerung der Strahlung des ersten, des zweiten und des dritten Wellenlängenbereichs Weißlicht emittiert wird, aufweisend:
- ein Substrat (1);
- eine erste Elektrode (2) und eine zweite Elektrode (6),
- wenigstens eine zwischen der ersten und zweiten Elektrode angeordnete erste Schichtenfolge (3), umfassend:
• zumindest eine erste Schicht (31) und eine dritte Schicht (33) mit jeweils einem fluoreszierenden Emitter, der Strahlung in dem ersten Wellenlängenbereich emittiert,
• genau eine zweite Schicht (32) mit einem ersten phosphoreszierenden Emitter, der ausschließlich Strahlung in dem zweiten Wellenlängenbereich emittiert,
• wobei die zweite Schicht (32) zwischen der ersten Schicht (31) und der dritten Schicht (33) angeordnet ist
- wenigstens eine zwischen der ersten und zweiten Elektrode angeordnete zweite Schichtenfolge (5), umfassend:
• zumindest eine erste Schicht (51) und eine dritte Schicht mit jeweils einem fluoreszierenden Emitter, der Strahlung in dem ersten Wellenlängenbereich emittiert,
• genau eine zweite Schicht (52) mit einem zweiten phosphoreszierenden Emitter, der ausschließlich Strahlung in dem dritten Wellenlängenbereich emittiert,
• wobei die zweite Schicht (52) zwischen der ersten Schicht (51) und der dritten Schicht angeordnet ist
- und wobei die fluoreszierenden Emitter der ersten und der zweiten Schichtenfolge Strahlung im blauen Wellenlängenbereich emittieren und der erste phosphoreszierende Emitter Strahlung im grünen Wellenlängenbereich und der zweite phosphoreszierende Emitter Strahlung im roten Wellenlängenbereich emittiert
- wenigstens eine Zwischenschicht (4), die frei von Emittermaterial ist und zwischen der ersten und der zweiten Schichtenfolge angeordnet ist, und
- zwischen der ersten Schicht (31) und der zweiten Schicht (32) und zwischen der zweiten Schicht (32) und der dritten Schicht (33) der ersten Schichtenfolge (3) und zwischen der ersten Schicht (51) und der zweiten Schicht (52) und zwischen der zweiten Schicht (52) und der dritten Schicht der zweiten Schichtenfolge jeweils eine Blockierschicht (7) angeordnet ist und die erste Schichtenfolge aus der ersten Schicht (31), der zweiten Schicht (32), der dritten Schicht (33) und den Blockierschichten (7) besteht und die zweite Schichtenfolge aus der ersten Schicht (51), der zweiten Schicht (52), der dritten Schicht und den Blockierschichten (7) besteht.

2. Strahlungsemittierende Vorrichtung nach dem vorhergehenden Anspruch, wobei Singulett- und Triplett-Exzitonen nur in der jeweils ersten Schicht (31, 51) der Schichtenfolge (3, 5) erzeugt werden.

3. Strahlungsemittierende Vorrichtung nach einem der vorhergehenden Ansprüche, wobei die erste Schicht der ersten Schichtenfolge und die dritte Schicht der ersten Schichtenfolge identisch sind.

4. Strahlungsemittierende Vorrichtung nach Anspruch 1 bis 3, wobei die erste Schicht der zweiten Schichtenfolge und die dritte Schicht der zweiten Schichtenfolge identisch sind.

5. Strahlungsemittierende Vorrichtung nach einem der vorhergehenden Ansprüche, wobei die Zwischenschicht (4) sowohl loch- als auch elektronenleitend ist.

6. Strahlungsemittierende Vorrichtung nach dem vorhergehenden Anspruch, wobei die Zwischenschicht (4) eine loch- und elektronenleitende organische Schicht und/oder eine Metallschicht und/oder eine Metalloxidschicht enthält.

7. Strahlungsemittierende Vorrichtung nach einem der vorhergehenden Ansprüche, wobei die erste Schicht (31) der ersten Schichtenfolge (3) und die erste Schicht (51) der zweiten Schichtenfolge (5) identisch sind.

8. Strahlungsemittierende Vorrichtung nach einem der Ansprüche 3 bis 7, wobei die dritte Schicht (33) der ersten Schichtenfolge (3) und die dritte Schicht der zweiten Schichtenfolge (5) identisch sind.

9. Strahlungsemittierende Vorrichtung nach einem der Ansprüche 3 bis 8, wobei im Betrieb Singulett- und Triplett-Exzitonen nur in der jeweils ersten Schicht (31, 51) der Schichtenfolgen (3, 5), der dritten Schicht (33) der ersten Schichtenfolge (3) und der dritten Schicht der zweiten Schichtenfolge (5) erzeugt werden.

## Claims

1. A radiation-emitting device for emitting electromagnetic radiation comprising a mixture of at least three different partial radiations of a first, a second, and a third wavelength range, wherein white light is emitted by a superposition of the radiation of the first, the second, and the third wavelength range, comprising:
- a substrate (1);
- a first electrode (2) and a second electrode (6),
- at least one first layer sequence (3) arranged between the first and second electrode, comprising:
• at least one first layer (31) and a third layer (33) each with a fluorescent emitter emitting radiation in the first wavelength range,
• exactly one second layer (32) with a first phosphorescent emitter exclusively emitting radiation in the second wavelength range,
• wherein the second layer (32) is arranged between the first layer (31) and the third layer (33)
- at least one second layer sequence (5) arranged between the first and second electrode, comprising:
• at least one first layer (51) and a third layer each with a fluorescent emitter emitting radiation in the first wavelength range,
• exactly one second layer (52) with a second phosphorescent emitter exclusively emitting radiation in the third wavelength range,
• wherein the second layer (52) is arranged between the first layer (51) and the third layer (53)
- and wherein the fluorescent emitters of the first and second layer sequences emit radiation in the blue wavelength range and the first phosphorescent emitter emits radiation in the green wavelength range and the second phosphorescent emitter emits radiation in the red wavelength range
- at least one intermediate layer (4) which is free of emitter material and is arranged between the first and the second layer sequence, and
- a blocking layer (7) is arranged between the first layer (31) and the second layer (32) and between the second layer (32) and the third layer (33) of the first layer sequence (3) and between the first layer (51) and the second layer (52) and between the second layer (52) and the third layer of the second layer sequence and the first layer sequence consists of the first layer (31), the second layer (32), the third layer (33) and the blocking layers (7) and the second layer sequence consists of the first layer (51), the second layer (52), the third layer and the blocking layers (7).

2. The radiation-emitting device according to the preceding claim, wherein singlet and triplet excitons are generated only in the respective first layer (31, 51) of the layer sequence (3, 5).

3. The radiation-emitting device according to one of the preceding claims, wherein the first layer of the first layer sequence and the third layer of the first layer sequence are identical.

4. The radiation-emitting device according to claim 1 to 3, wherein the first layer of the second layer sequence and the third layer of the second layer sequence are identical.

5. The radiation-emitting device according to one of the preceding claims, wherein the intermediate layer (4) is both hole and electron conducting.

6. The radiation-emitting device according to the preceding claim, wherein the intermediate layer (4) comprises a hole and electron conducting organic layer and/or a metal layer and/or a metal oxide layer.

7. The radiation-emitting device according to one of the preceding claims, wherein the first layer (31) of the first layer sequence (3) and the first layer (51) of the second layer sequence (5) are identical.

8. The radiation-emitting device according to one of the claims 3 to 7, wherein the third layer (33) of the first layer sequence (3) and the third layer of the second layer sequence (5) are identical.

9. The radiation-emitting device according to one of the claims 3 to 8, wherein, during operation, singlet and triplet excitons are generated only in the respective first layer (31, 51) of the layer sequences (3, 5), the third layer (33) of the first layer sequence (3) and the third layer of the second layer sequence (5).

## Revendications

1. Dispositif d'émission de rayonnement pour émettre un rayonnement électromagnétique comprenant un mélange d'au moins trois rayonnements partiels différents d'une première, d'une deuxième et d'une troisième gamme de longueurs d'onde, dans lequel une lumière blanche est émise par une superposition du rayonnement de la première, de la deuxième et de la troisième gamme de longueurs d'onde, comprenant:
- un substrat (1);
- une première électrode (2) ; et une seconde électrode (6),
- au moins une première séquence de couches (3) disposée entre les première et deuxième électrodes, comprenant:
• au moins une première couche (31) et une troisième couche (33) comprenant chacune un émetteur fluorescent émettant un rayonnement dans la première gamme de longueurs d'onde,
• précisément une deuxième couche (32) comprenant un premier émetteur phosphorescent émettant un rayonnement exclusivement dans la deuxième gamme de longueurs d'onde,
• dans lequel la deuxième couche (32) est disposée entre la première couche (31) et la troisième couche (33)
- au moins une deuxième séquence de couches (5) disposée entre les première et deuxième électrodes, comprenant:
• au moins une première couche (51) et une troisième couche comprenant chacune un émetteur fluorescent émettant un rayonnement dans la première gamme de longueurs d'onde,
• précisément une deuxième couche (52) comprenant un deuxième émetteur phosphorescent émettant un rayonnement exclusivement dans la troisième gamme de longueurs d'onde,
• dans lequel la deuxième couche (52) est disposée entre la première couche (51) et la troisième couche
- et dans lequel les émetteurs fluorescents des première et deuxième couches émettent un rayonnement dans la région de la longueur d'onde bleue et le premier émetteur phosphorescent émet un rayonnement dans la région de la longueur d'onde verte et le deuxième émetteur phosphorescent émet un rayonnement dans la région de la longueur d'onde rouge
- au moins une couche intermédiaire (4) qui est exempte de matériau émetteur et qui est disposée entre la première et la deuxième séquence de couches, et
- une couche de blocage (7) est disposée entre la première couche (31) et la deuxième couche (32) et entre la deuxième couche (32) et la troisième couche (33) de la première séquence de couches (3) ainsi qu'entre la première couche (51) et la deuxième couche (52) et entre la deuxième couche (52) et la troisième couche de la deuxième séquence de couches, et la première séquence de couches consiste en la première couche (31), la deuxième couche (32), la troisième couche (33) et les couches de blocage (7) et la deuxième séquence de couches consiste en la première couche (51), la deuxième couche (52), la troisième couche et les couches de blocage (7).

2. Dispositif d'émission de rayonnement selon la revendication précédente, dans lequel des excitons singlets et triplets sont générés uniquement dans la première couche respective (31, 51) de la séquence de couches (3, 5).

3. Dispositif d'émission de rayonnement selon l'une quelconque des revendications précédentes, dans lequel la première couche de la première séquence de couches et la troisième couche de la première séquence de couches sont identiques.

4. Dispositif d'émission de rayonnement selon la revendication 1 à 3, dans lequel la première couche de la deuxième séquence de couches et la troisième couche de la deuxième séquence de couches sont identiques.

5. Dispositif d'émission de rayonnement selon l'une quelconque des revendications précédentes, dans lequel la couche intermédiaire (4) est à la fois conductrice de trous et d'électrons.

6. Dispositif d'émission de rayonnement selon la revendication précédente, dans lequel la couche intermédiaire (4) comprend une couche organique conductrice de trous et d'électrons et/ou une couche métallique et/ou une couche d'oxyde métallique.

7. Dispositif d'émission de rayonnement selon l'une quelconque des revendications précédentes, dans lequel la première couche (31) de la première séquence de couches (3) et la première couche (51) de la deuxième séquence de couches (5) sont identiques.

8. Dispositif d'émission de rayonnement selon l'une quelconque des revendications 3 à 7, dans lequel la troisième couche (33) de la première séquence de couches (3) et la troisième couche de la deuxième séquence de couches (5) sont identiques.

9. Dispositif d'émission de rayonnement selon l'une quelconque des revendications 3 à 8, dans lequel, en opération, des excitons de singlet et de triplet sont générés uniquement dans la première couche respective (31, 51) des séquences de couches (3, 5), la troisième couche (33) de la première séquence de couches (3) et la troisième couche de la deuxième séquence de couches (5).
